# EUROPEAN PATENT APPLICATION

(11) **EP 2 273 765 A1**
(43) Date of publication of application: **12.01.2011**
(21) Application number: 09728891.4
(22) Date of filing: 04.03.2009
(51) Int. Cl.: H04M 1/02, H01L 31/12

(54) **OPTICAL COMMUNICATION STRUCTURE**

(30) Priority: 03.04.2008 JP 2008097332
(71) Applicant: Hosiden Corporation, Yao-shi, Osaka 581-0071 (JP)
(72) Inventor: NAKAGAWA, Hiroshi, Yao-shi Osaka 581-0071 (JP); ISODA, Takeshi, Yao-shi Osaka 581-0071 (JP); SASADA, Kosuke, Yao-shi Osaka 581-0071 (JP)
(74) Representative: Lemcke, Brommer & Partner
(86) International application number: PCT/JP2009/054078
(87) International publication number: WO 2009/122848

(57) **Abstract**

An optical communication structure for performing optical communication using optical signals between a first housing (2) and a second housing (3) slidable to each other includes: a first optical communication element (12) which is provided in the first housing (2) and configured to transmit the optical signal; a second optical communication element (13) which is provided in the second housing (3) and configured to receive the optical signal transmitted from the first optical communication element (12); a sliding module configured to allow the sliding movement of the housings and stop the sliding movement at predetermined stop positions set in advance; and a light guide plate (4) which is provided in one of the first housing (2) and the second housing (3) and configured to reflect the optical signal, and has the same number of reflecting portions (5) as the number of the stop positions.

## Description

### Technical Field

The present invention relates to an optical communication structure for performing optical communication using optical signals between a first housing and a second housing slidable to each other.

### Background Art

In recent years, portable terminals, such as mobile-phone and portable music player, have become remarkably in widespread use. One reason behind this is a trend of moving up to a higher functionality in the portable terminal. The mobile-phone may have a function of transmitting and receiving e-mails, a function of browsing websites, or the like. Further, the mobile-phone may have a camera function of shooting a subject, or a function of receiving terrestrial digital broadcasting. On the other hand, the portable music player may have a function of downloading music from websites. There arises a problem that, as the trend of moving up to a higher functionality proceeds, a hardware forming the portable terminal should become larger. In order to solve this problem, there have been proposed techniques in which the portable terminal is downsized (see, for example, Patent Document 1).

A portable electronic device described in Patent Document 1 has a structure in which a housing formed of a first unit and another housing formed of a second unit are connected to each other in such a manner that they can be opened and closed through sliding movements. With this structure, when the portable electronic device is not to be used, both housings are slidably moved in a closing direction to thereby downsize the device. On the other hand, when the portable electronic device is to be used, both housings are slidably moved in an opening direction, to thereby bring various functions provided in the portable electronic device into a usable state. In addition, in this portable electronic device, optical communication elements are provided in respective housings, so that optical communication between the housings becomes possible even when both housings are slidably moved and relatively displaced. Then, in accordance with the sliding movement of the housings, a space connecting both optical communication elements is formed, which is utilized for the optical communication.

In the technique described in Patent Document 1, it is configured that a communication light irradiated from one of the optical communication elements enters the other optical communication element, through a parallel light lens for forming parallel light and a shift lens for shifting a communication light path to a predetermined angle, both provided before and after the space as optical channel. Therefore, a relative positional relationship between the parallel light lens and the shift lens is extremely important, and high accuracy is required in assembling the device. Accordingly, when the accuracy cannot be retained, there may be a communication error between the optical communication elements.
Patent Literature 1: Japanese Unexamined Patent Application Publication No. 2003-348203 (paragraphs 0008, 0010, 0032 and the like)

### Summary of Invention

In view of the above, an object of the present invention is to provide an optical communication structure capable of performing appropriate optical communication between a pair of optical communication elements provided in the respective housings slidable to each other, even when a sliding movement between a pair of the housings is performed.

In one aspect of the present invention to attain the above-described object, the optical communication structure for performing optical communication using optical signals between a first housing and a second housing slidable to each other includes: a first optical communication element which is provided in the first housing and configured to transmit the optical signal; a second optical communication element which is provided in the second housing and configured to receive the optical signal transmitted from the first optical communication element; a sliding module configured to allow the sliding movement of the housings and stop the sliding movement at predetermined stop positions set in advance; and a light guide plate which is provided in one of the first housing and the second housing and configured to reflect the optical signal, and has the same number of reflecting portions as the number of the stop positions.

With this configuration, the reflecting portion configured to reflect the optical signal in accordance with the stop position for the sliding movement is provided. Accordingly, even when the sliding movement between the first housing and the second housing is performed, the optical signal transmitted from the first optical communication element can be surely reflected to the second optical communication element. Therefore, it becomes possible to appropriately perform the optical communication between the first optical communication element and the second optical communication element.

In addition, it is preferable that a light-emitting face of the first optical communication element and a light-receiving face of the second optical communication element are orthogonally oriented, and the reflecting portion is configured to reflect the optical signal transmitted from the first optical communication element at an angle of 90 degrees in a direction towards the second optical communication element.

With this configuration, the reflecting portion reflects the optical signal at an angle of 90 degrees, and a positional displacement to some extent between the first optical communication element and the second optical communication element can be allowed. Accordingly, a manufacturing yield can be improved.

In addition, it is preferable that an optical communication element provided in a housing in which the light guide plate is not provided from between the first housing and the second housing is configured to move parallelly relative to the light guide plate.

With this configuration, a positioning between the reflecting portion formed in the light guide plate and the optical communication element can be easily performed in accordance with the sliding movement between the first housing and the second housing. Accordingly, it becomes possible to use the reflecting portion of the light guide plate in accordance with the slide position and it becomes possible to appropriately perform the optical communication between the first optical communication element and the second optical communication element.

In addition, it is preferable that a lens portion for adjusting a focal point of the optical signal reflected from the reflecting portion is formed in the light guide plate.

With this configuration, the optical signal is reflected at an angle of 90 degrees, whose focal point coincides with the lens portion. Therefore, further positional displacement can be allowed. Accordingly, the manufacturing yield can be further improved.

In addition, it is preferable that a lens center of the lens portion is eccentric.

With this configuration, even when the optical signal is reflected from the light-receiving face, the optical signal is prevented from returning to the light-emitting face. Therefore, the optical communication element having the light-emitting face can be prevented from malfunction.

### Brief Description of Drawings

Fig. 1 is a diagram showing a schematic configuration of a mobile-phone having an optical communication structure according to one embodiment of the present invention.
Fig. 2 shows diagrams of stop positions for sliding movement.
Fig. 3 is a schematic view showing a positional relationship of a first optical communication element, a second optical communication element, and a light guide plate.
Fig. 4 is a diagram showing one example of a structure for preventing malfunction.
Fig. 5 is a diagram showing another example of a structure for preventing malfunction.

### Description of Embodiments

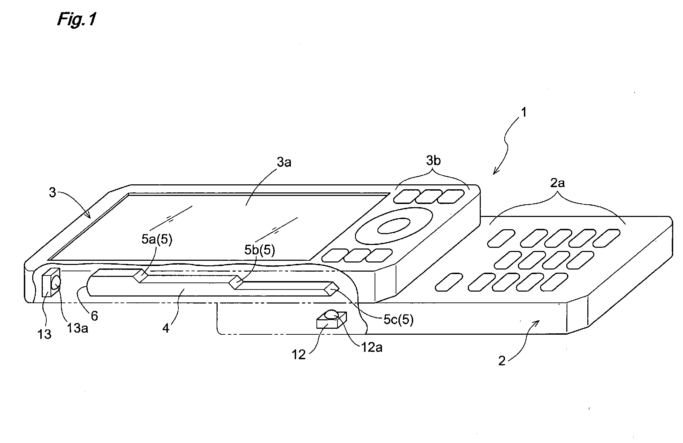

Hereinbelow, an embodiment of the present invention will be described with reference to the drawings. Fig. 1 is a diagram showing a schematic configuration of a mobile-phone 1 having an optical communication structure according to one embodiment of the present invention. The optical communication structure according to the present invention has a function of performing optical communication using optical signals between a first housing 2 and a second housing 3 slidable to each other, mainly in a portable terminal, such as the mobile-phone 1 and portable music player. In the following descriptions, the present optical communication structure is illustrated as those applied to the mobile-phone 1.

As shown in Fig. 1, the mobile-phone 1 is formed of the first housing 2 and the second housing 3 slidable to each other. The first housing 2 is provided with buttons 2a which are used for performing various operations of the mobile-phone 1. Examples of the various operations of the mobile-phone 1 include: in the case of a telephone function, an operation of inputting a telephone number to call; and in the case of an e-mail function, an operation of inputting character information. Further examples include: in the case of a camera function, an operation of shooting a subject; and in the case of a television function, an operation of selecting a reception frequency of a tuner.

The second housing 3 is provided with a display screen 3a for displaying various types of information and buttons 3b. Various types of information include information corresponding to the above-described various types of operations. Specifically, examples of the various types of information include: in the case of the telephone function or e-mail function, a telephone number, character information or the like input through the buttons 2a. In the case of the camera function, the subject displayed on the display screen 3a as a fmder, when shooting the subject, corresponds to the information. In the case of the television function, the received program corresponds to the information described above.

In order to display such operations and information, it is necessary to establish communication between a first control unit (not shown) provided in the first housing 2 and a second control unit (not shown) provided in the second housing 3, so as to transmit and receive data or the like. In the present embodiment, the communication is performed by optical communication using optical signals, without using a signal line. In the present embodiment, the optical communication is realized using: a first optical communication element 12 which is provided in the first housing 2 and is configured to transmit an optical signal; and a second optical communication element 13 which is provided in the second housing 3 and is configured to receive the optical signal transmitted from the first optical communication element 12.

It should be noted that the first optical communication element 12 is provided inside the first housing 2, while the second optical communication element 13 is provided inside the second housing 3. Therefore, the optical communication between the first optical communication element 12 and the second optical communication element 13 is also performed inside the housing, including the first housing 2 and the second housing 3.

As shown in Fig. 1, the first optical communication element 12 and the second optical communication element 13 are arranged in such a manner that a light-emitting face 12a of the first optical communication element 12 and a light-receiving face 13a of the second optical communication element 13 are oriented orthogonally to each other. Therefore, in order to allow the second optical communication element 13 to receive an optical signal transmitted from the first optical communication element 12, an optical axis of the optical signal should be changed.

In order to change the optical axis of the optical signal, in the present optical communication structure, a light guide plate 4 is provided. The light guide plate 4 is provided in one of the first housing 2 and the second housing 3, and has a reflecting portion 5 for reflecting the optical signal. In the present embodiment, the light guide plate 4 is illustrated as being provided in the second housing 3. It should be noted that the light guide plate 4 may also be provided in the housing (the second housing 3), like the first optical communication element 12 and the second optical communication element 13.

As shown in Fig. 1, three reflecting portions 5 (5a,5b,5c) are formed in the light guide plate 4. Though the details will be described later, each of the reflecting portions 5a,5b,5c changes the optical axis of the optical signal as incident light, in accordance with a formed angle of the corresponding reflecting portion. Therefore, the light guide plate 4 has a function of changing a direction of the optical axis of the optical signal transmitted from the first optical communication element 12 into a direction toward the second optical communication element 13, by utilizing the reflecting portions 5a,5b,5c formed in the light guide plate 4.

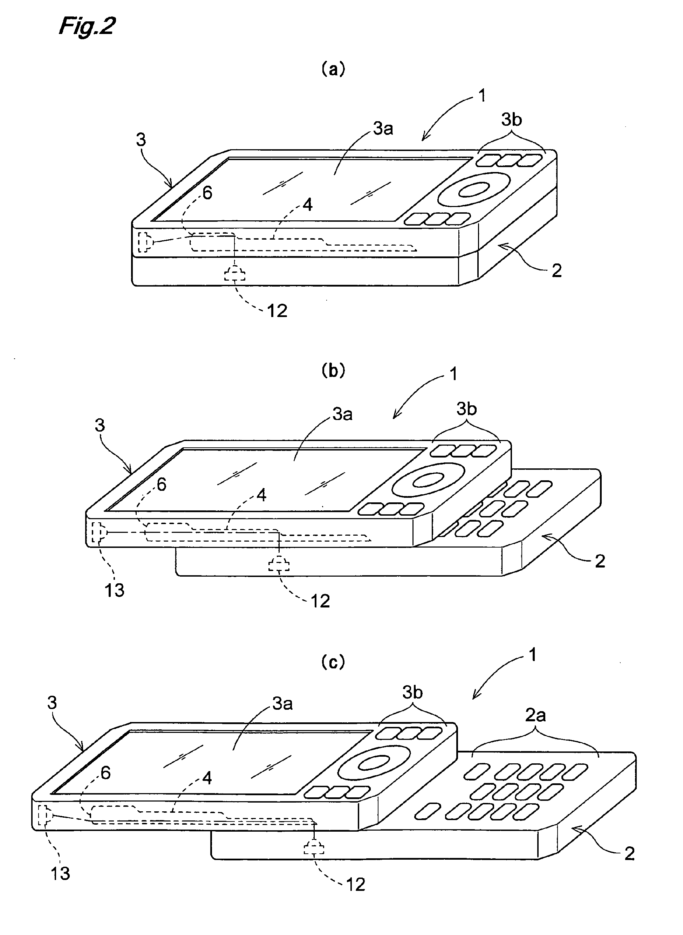

Herein, the mobile-phone 1 having the optical communication structure according to the present invention is formed of the first housing 2 and the second housing 3 slidable to each other as described above. This sliding movement is realized by a sliding module (not shown) provided in the mobile-phone 1. The sliding module has a function of sliding the first housing 2 and the second housing 3 relative to each other and stopping the sliding movement of the housings at predetermined stop positions set in advance. The predetermined stop position means a position at which the sliding movement is stopped. The stop position is set in advance by the sliding module. In the present embodiment, the position at which the sliding movement is stopped is illustrated to include three positions as shown in Fig. 2.

Fig. 2(a) shows a state in which a sliding distance between the first housing 2 and the second housing 3 is the smallest. In the following description, this state is referred to as a first state. Fig. 2(c) shows a state in which the sliding distance between the first housing 2 and the second housing 3 is the largest. In the following description, this state is referred to as a third state. Fig. 2(b) shows a state in which a sliding distance is approximately a half of the sliding distance of the third state. In the following description, this state is referred to as a second state. In this manner, in the present embodiment, the stop position includes three positions corresponding to the first state, the second state, and the third state. As the reflecting portion 5 described above, the same number of the reflecting portions (5a,5b,5c) as the number of the stop positions are formed (see Fig. 1).

As described above, the light-emitting face 12a of the first optical communication element 12 and the light-receiving face 13a of the second optical communication element 13 are orthogonally oriented. Therefore, the reflecting portion 5 formed in the light guide plate 4 is configured to reflect an optical signal output from the first optical communication element 12 at an angle of 90 degrees in a direction towards the second optical communication element 13. Hereinbelow, the description will be made with reference to the drawings.

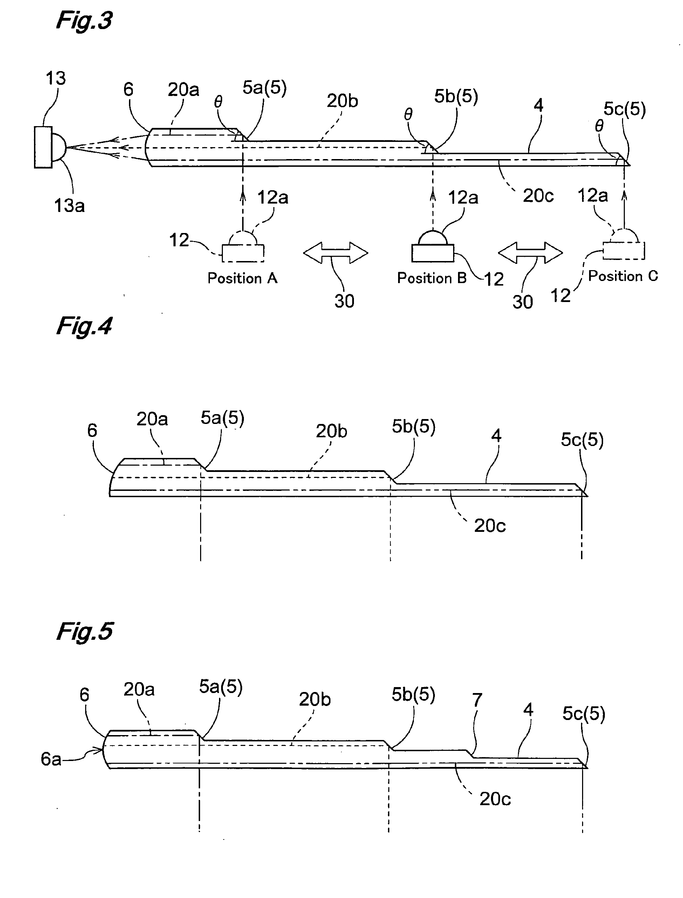

Fig. 3 is a schematic view showing a positional relationship of the first optical communication element 12, the second optical communication element 13, and the light guide plate 4. In Fig. 3, for the purpose of facilitating the understanding, the components other than the first optical communication element 12, the second optical communication element 13, and the light guide plate 4 are omitted. An optical communication element provided in the housing in which the light guide plate 4 is not provided, from between the first housing 2 and the second housing 3, is configured to move parallelly relative to the light guide plate 4. In other words, in the present embodiment, as shown with outlined arrows 30 in Fig. 3, the optical communication element 12 provided in the first housing 2 in which the light guide plate 4 is not provided is configured to move parallelly relative to the light guide plate 4.

In the first state, the first optical communication element 12 is positioned at a position A shown in Fig. 3. In this case, the optical signal transmitted from the light-emitting face 12a of the first optical communication element 12 is directed (emitted) to the reflecting portion 5a formed in the light guide plate 4, as shown with a line 20a (dashed-dotted line). Then, the reflecting portion 5a reflects the transmitted optical signal in an orthogonal direction. In other words, a direction of an optical axis of the optical signal transmitted from the light-emitting face 12a is changed into the orthogonal direction by the reflecting portion 5a. Therefore, it is preferable that a forming angle θ of the reflecting portion 5a be 45 degrees. The optical signal reflected from the reflecting portion 5a is propagated along the light guide plate 4.

Herein, in order to allow the optical signal propagated along the light guide plate 4 to be appropriately received by the light-receiving face 13a of the second optical communication element 13, a lens portion 6 for adjusting a focal point the optical signal reflected from the reflecting portion 5a is formed in the light guide plate 4. The optical axis of the optical signal reflected from the reflecting portion 5a is changed by the lens portion 6 and the optical signal can be appropriately received by the light-receiving face 13a of the second optical communication element 13.

Likewise, in the second state, the first optical communication element 12 is positioned at a position B shown in Fig. 3. In this case, the optical signal transmitted from the light-emitting face 12a of the first optical communication element 12 is directed (emitted) to the reflecting portion 5b formed in the light guide plate 4, as shown with a line 20b (dotted line). Then, the reflecting portion 5b reflects the transmitted optical signal in an orthogonal direction. In other words, a direction of an optical axis of the optical signal transmitted from the light-emitting face 12a is changed into the orthogonal direction by the reflecting portion 5b. Therefore, it is preferable that a forming angle θ of the reflecting portion 5b be 45 degrees. The optical signal reflected from the reflecting portion 5b is propagated along the light guide plate 4. The optical axis of the optical signal reflected from the reflecting portion 5b is changed by the lens portion 6 and the optical signal can be appropriately received by the light-receiving face 13 a of the second optical communication element 13.

In the third state, the first optical communication element 12 is positioned at a position C shown in Fig. 3. In this case, the optical signal transmitted from the light-emitting face 12a of the first optical communication element 12 is directed (emitted) to the reflecting portion 5c formed in the light guide plate 4, as shown with a line 20c (dashed-two dotted line). Then, the reflecting portion 5c reflects the transmitted optical signal in an orthogonal direction. In other words, a direction of an optical axis of the optical signal transmitted from the light-emitting face 12a is changed into the orthogonal direction by the reflecting portion 5c. Therefore, it is preferable that a forming angle θ of the reflecting portion 5c be 45 degrees. The optical signal reflected from the reflecting portion 5c is propagated along the light guide plate 4. The optical axis of the optical signal reflected from the reflecting portion 5c is changed by the lens portion 6 and the optical signal can be appropriately received by the light-receiving face 13a of the second optical communication element 13. In this manner, in the present optical communication structure, the optical signal transmitted from the first optical communication element 12 can be appropriately received by the second optical communication element 13.

Herein, in the case of the second state (position B) shown in Fig. 3, the optical signal reflected from the reflecting portion 5b passes a lens center of the lens portion 6, and is emitted on the light-receiving face 13a of the second optical communication element 13. In this case, the optical signal may be reflected from the light-receiving face 13a and return to the first optical communication element 12, and such a returning optical signal may cause malfunction of the first optical communication element 12. In the present optical communication structure, it is preferable to introduce a structure that can prevent such a malfunction. Such a structure is illustrated in Figs. 4 and 5.

Fig. 4 is a diagram showing one example of a structure suitable for preventing malfunction as described above. A lens center of the lens portion 6 of the light guide plate 4 shown in Fig. 4 is formed to be eccentric. Therefore, the optical signal reflected from the light-receiving face 13a of the second optical communication element 13 can be prevented from returning to the first optical communication element 12.

In addition, Fig. 5 shows another example of a structure suitable for preventing malfunction. In addition to the reflecting portions 5a,5b,5c of the light guide plate 4 shown in Fig. 5, a position adjustor 7 is formed for adjusting a position of the optical signal reflected from each of the reflecting portions 5a,5b,5c, so as not to pass a lens center 6a of the lens portion 6. Especially, Fig. 5 illustrates a case in which the position of the reflecting portion 5b is adjusted (by providing the position adjustor 7, the position of the reflecting portion 5b relative to a transverse direction of the light guide plate 4 is displaced away from the lens center 6a). With such a structure for preventing malfunction, the optical signal reflected from the light-receiving face 13a of the second optical communication element 13 can be surely prevented from returning to the first optical communication element 12.

With such an optical communication structure, even when the sliding movement between the first housing 2 and the second housing 3 is performed, the optical signal transmitted from the first optical communication element 12 can be surely reflected to the second optical communication element 13. Therefore, the optical communication can be appropriately performed between the first optical communication element 12 and the second optical communication element 13. In addition, the reflection of the optical signal from the light-receiving face 13a can be prevented, and malfunction of the optical communication element 12 having the light-emitting face 12a can be prevented.

### <Other embodiments>

In the embodiment described above, the optical communication structure according to the present invention is illustrated as those applied to the mobile-phone 1. However, a range to which the present invention can be applied is not limited to this configuration. It is of course possible to apply the optical communication structure to a portable music player. In addition, it is of course possible to apply the present invention to a terminal having a plurality of housings slidable to one another.

In the embodiment described above, the first optical communication element 12 is configured to transmit an optical signal and the second optical communication element 13 is configured to receive the optical signal transmitted from the first optical communication element 12. However, a range to which the present invention can be applied is not limited to this configuration. For example, the second optical communication element 13 may be configured to transmit an optical signal and the first optical communication element 12 may be configured to receive the optical signal transmitted from the second optical communication element 13. Even with such a configuration, it is of course possible to appropriately perform the optical communication between the communication elements.

In the embodiment described above, the light-emitting face 12a of the first optical communication element 12 and the light-receiving face 13a of the second optical communication element 13 are orthogonally oriented, and the reflecting portion 5 is configured to reflect the optical signal transmitted from the first optical communication element 12 at an angle of 90 degrees in a direction towards the second optical communication element 13. However, a range to which the present invention can be applied is not limited to this configuration. Even though the light-emitting face 12a of the first optical communication element 12 and the light-receiving face 13a of the second optical communication element 13 are not orthogonally oriented, it is of course possible to perform the optical communication between the first optical communication element 12 and the second optical communication element 13, by configuring the reflecting portion 5 to reflect the optical signal transmitted from the first optical communication element 12 towards the second optical communication element 13.

In the embodiment described above, the optical signal transmitted from the first optical communication element 12 is received by the second optical communication element 13. However, a range to which the present invention can be applied is not limited to this configuration. For example, when the first optical communication element 12 and the second optical communication element 13 are formed of optical communication modules for performing both transmitting and receiving optical signals, the optical signal transmitted from the second optical communication element 13 can be received by the first optical communication element 12. In this case, it is preferable that the lens body 6 for adjusting a focal point of an optical signal is provided also to a face corresponding to the first optical communication element 12 from among the faces of the light guide plate 4.

### Industrial Applicability

The present invention can be applied to the optical communication performed between a pair of the optical communication elements provided in the respective housings slidable to each other, when the sliding movement between a pair of the housings is performed.

## Claims

1. An optical communication structure for performing optical communication using optical signals between a first housing and a second housing slidable to each other, comprising:
a first optical communication element which is provided in the first housing and configured to transmit the optical signal;
a second optical communication element which is provided in the second housing and configured to receive the optical signal transmitted from the first optical communication element;
a sliding module configured to allow the sliding movement of the housings and stop the sliding movement at predetermined stop positions set in advance; and
a light guide plate which is provided in one of the first housing and the second housing and configured to reflect the optical signal, and has the same number of reflecting portions as the number of the stop positions.

2. The optical communication structure according to claim 1, wherein
a light-emitting face of the first optical communication element and a light-receiving face of the second optical communication element are orthogonally oriented, and
the reflecting portion is configured to reflect the optical signal transmitted from the first optical communication element at an angle of 90 degrees in a direction towards the second optical communication element.

3. The optical communication structure according to claim 1 or 2, wherein an optical communication element provided in a housing in which the light guide plate is not provided from between the first housing and the second housing is configured to move parallelly relative to the light guide plate.

4. The optical communication structure according to any one of claims 1 to 3, wherein a lens portion for adjusting a focal point of the optical signal reflected from the reflecting portion is formed in the light guide plate.

5. The optical communication structure according to claim 4, wherein a lens center of the lens portion is eccentric.
